# EUROPEAN PATENT SPECIFICATION

(11) **EP 3 440 697 B1**
(45) Date of publication and mention of the grant of the patent: **28.12.2022**
(21) Application number: 17719767.0
(22) Date of filing: 07.04.2017
(51) Int. Cl.: H01L 23/495, H01L 21/48, H01L 23/31, H01L 21/56

(54) **FLAT NO-LEADS PACKAGE WITH IMPROVED CONTACT LEADS**
FLACHES NO-LEADS-GEHÄUSE MIT VERBESSERTEN KONTAKTDRÄHTEN
BOÎTIER PLAT SANS CONDUCTEURS À CONDUCTEURS DE CONTACT AMÉLIORÉS

(30) Priority: 07.04.2016 US 201662319512 P; 06.04.2017 US 201715480661
(43) Date of publication of application: 13.02.2019
(73) Proprietor: Microchip Technology Incorporated, Chandler, AZ 85224-6199 (US)
(72) Inventor: KITNARONG, Rangsun, Nonthaburi 11000 (TH); PUNYAPOR, Prachit, Pathumtani 12130 (TH); POOLSUP, Pattarapon, Bangkok 10530 (TH); KUMSAI, Swat, Chiang Mai 50280 (TH)
(74) Representative: sgb europe
(86) International application number: PCT/US2017/026500
(87) International publication number: WO 2017/177080

(56) References cited:
- WO-A1-2016/081806
- JP-A- 2008 112 961
- US-B1- 7 008 825
- US-B1- 8 017 447

## Description

### TECHNICAL FIELD

The present disclosure relates to integrated circuit packaging, in particular to so-called flat no-leads packaging for integrated circuits, installed on a printed circuit board.

### BACKGROUND

Flat no-leads packaging refers to a type of integrated circuit (IC) packaging with integrated pins for surface mounting to a printed circuit board (PCB). Flat no-leads may sometimes be called micro leadframes (MLF). Flat no-leads packages, including for example quad-flat no-leads (QFN) and dual-flat no-leads (DFN), provide physical and electrical connection between an encapsulated IC component and an external circuit (*e.g.,* to a printed circuit board (PCB)).

In general, the contact pins for a flat no-leads package do not extend beyond the edges of the package. The pins are usually formed by a single leadframe that includes a central support structure for the die of the IC. The leadframe and IC are encapsulated in a housing, typically made of plastic. Each leadframe may be part of a matrix of leadframes that has been molded to encapsulate several individual IC devices. Usually, the matrix is sawed apart to separate the individual IC devices by cutting through any joining members of the leadframe. The sawing or cutting process also exposes the contact pins along the edges of the packages.

Once sawn, the bare contact pins may provide bad or no connection for reflow soldering. Reflow soldering is a preferred method for attaching surface mount components to a PCB, intended to melt the solder and heat the adjoining surfaces without overheating the electrical components, and thereby reducing the risk of damage to the components. The exposed face of contact pins may not provide sufficient wettable flanks to provide a reliable connection.

US 8017447 B1 discloses a method of preparing a portion of the side of a terminal of an Integrated Circuit (IC) package for solder. The method comprises the steps of attaching an IC die to a leadframe comprising a connecting bar, reducing the thickness of a portion of the connecting bar, overmolding the leadframe with a mold compound, removing the mold compound from the reduced-thickness portion of the connecting bar using a laser, coating the reduced-thickness portion of the connecting bar with a solder-wettable material, and cutting through the thickness of the connecting bar within the reduced thickness portion of the connecting bar, wherein the cut has a width that is less than the width of the reduced thickness portion of the connecting bar.

JP2008112961A discloses a semiconductor manufacturing method and a semiconductor device, in which the reliability of connection with a wiring board is improved. In the manufacturing of a semiconductor device, a groove with prescribed width is formed from the lower surface of a frame part of a lead frame sealed with seal resin along a dicing line by a dicing saw. Then, a plating layer is formed on the bottom and side face of the groove, the lower surface of a die pad and the lower surface of a lead. Then, the frame part and the seal resin are penetrated and removed along the dicing line by a dicing saw having width narrower than that of the groove. Consequently, a lead plating layer is formed on the inside end face of a body part of the lead to obtain an individual semiconductor device.

US 7008825 B1 discloses a method of fabricating a semiconductor package. The method comprises the step of providing a leadframe strip which defines a strip plane and a multiplicity of leadframes. Each of the leadframes includes an outer frame defining a central opening and a die pad disposed within the central opening. Each leadframe further includes a plurality of leads which are attached to the outer frame and extend toward the die pad in spaced relation to each other. The outer frames are integrally connected to each other and collectively define connecting bars which extend in multiple rows and columns and define saw streets. Semiconductor dies are attached to respective ones of the die pads, with the semiconductor dies being mechanically and electrically connected to the leads of respective ones of the leadframes. Thereafter, an encapsulant material is applied to the leadframe strip to form at least one mold cap which at least partially encapsulates the leadframes, the semiconductor dies, and the conductive wires. The leadframe strip and the mold cap collectively define a package strip. Isolation cuts are formed through the package strip along at least some of the saw streets to effectively electrically isolate the leadframes from each other.

WO 2016/081806 A1 teaches a method for manufacturing an integrated circuit device. The method includes mounting an IC chip onto a center support structure of a leadframe, bonding the IC chip to at least some of the plurality of pins, encapsulating the leadframe and bonded IC chip, sawing a step cut into the encapsulated leadframe, plating the exposed portion of the plurality of pins, and cutting the IC package free from the bar. The leadframe includes a plurality of pins extending from the center support structure and a bar connecting the plurality of pins remote from the center support structure. The step cut may be sawn into the encapsulated leadframe along a set of cutting lines using a first saw width without separating the bonded IC package from the bar, thereby exposing at least a portion of the plurality of pins. The IC package may be cut free from the bar by sawing through the encapsulated lead frame at the set of cutting lines using a second saw width less than the first saw width.

### SUMMARY

On the basis of the prior art, an object exists to provide an improved method for manufacturing an integrated circuit and providing a corresponding integrated circuit. The object is solved by the method and integrated circuit according to the independent claims.

According to one aspect of the invention, a method for manufacturing an integrated circuit (IC) device in a flat no-leads package and attaching the device on a printed circuit board is provided. The method comprises:
providing a pre-grooved leadframe (40);
mounting an IC chip onto a center support structure (42) of the pre-grooved leadframe (40), the pre-grooved leadframe (40) including:
   a plurality of pins (44) extending from the center support structure (42);
   a groove (48) running perpendicular to the individual pins (44) of the plurality of pins (44) around the center support structure (42); and
   a bar (46) connecting the plurality of pins (44) remote from the center support structure (42);
bonding the IC chip to at least some of the plurality of pins (44);
encapsulating the pre-grooved leadframe (40) and bonded IC chip, including filling the groove (48) with encapsulation compound;
removing the encapsulation compound from the groove (48), thereby exposing at least a portion of the individual pins (44) of the plurality of pins (44);
plating the exposed portion of the plurality of pins (44);
performing an isolation cut using a second saw width less than a width of the groove (48) to isolate individual pins (44) of the IC package (10) without separating the IC package (10) from the lead frame (40);
performing a circuit test of the isolated individual pins (44) after the isolation cut;
cutting the IC package (10) free from the bar (46) by sawing through the encapsulated lead frame (40) along the groove (48) using a first saw width less than a width of the groove (48); and
attaching the flat no-leads IC package (10) to the printed circuit board using a reflow soldering method to join the plurality of pins (44) of the IC package (10) to respective contact points on the printed circuit board; wherein
the groove (48) is 0.1 mm to 0.15 mm deep, the pre-grooved leadframe (40) has a thickness of 0.20 mm, and individual pins (44) of the plurality of pins (44) are attached to a printed circuit board with fillet heights of 60% of the exposed surface of the pins (44).

According to a second aspect of the invention, an integrated circuit (IC) device in a flat no-leads package (10), installed on a printed circuit board is provided. The integrated circuit device comprises:
an IC chip mounted onto a center support structure (42) of a pre-grooved leadframe (40) and encapsulated with the pre-grooved leadframe (40) to form an IC package (10) having a bottom face and four sides;
the pre-grooved leadframe (40) including a set of pins (44) extending from the center support structure (42), a groove (48) running perpendicular to the individual pins (44) of the plurality of pins (44) around the center support structure (42) , and a bar (46) connecting the plurality of pins (44) remote from the center support structure (42);
the set of pins (44) having faces exposed along a lower edge of the four sides of the IC package (10); and
the groove (48) running around a perimeter of the bottom face of the IC package (10), including the exposed faces of the set of pins (44);
the groove (48) having a depth of is 0.1 mm to 0.15 mm and the pre-grooved leadframe (40) has a thickness of 0.20 mm;
wherein a bottom facing exposed portion of the plurality of pins (44) including the groove (48) is plated; and wherein
individual pins (44) of the plurality of pins (44) are attachable to the printed circuit board so that fillet heights of 60% of the exposed surface of the pins (44) are achievable.

A method that improves the wettable surface of flat no-leads contact pins for a reflow soldering process to mount the flat no-leads package to an external circuit is provided that improves the electrical and mechanical performance of an IC in a QFN or other flat no-leads package. The "wettable flanks" provided in a QFN or other flat no-leads package package are improved by using saw step cut process on a pre-grooved lead frame with a precise groove depth.

Using a saw step cut process alone may result in high variation in cutting depth (e.g., low precision of depth) and leave copper burrs on the lead frame. Using a pre-grooved lead frame improves the precision and/or consistency of the cutting depth and fillet height. For example, using a laser to remove material reduces the potential creation of copper burrs that might result from a conventional saw step cut. US Patent Application 14/946,024, "QFN PACKAGE WITH IMPROVED CONTACT PINS" filed 11/19/2015 discloses an improvement of the wettable flanks of a QFN semiconductor device.

According to the first aspect of the invention, a method for manufacturing an integrated circuit (IC) device in a flat no-leads package is provided. The method includes mounting an IC chip onto a center support structure of a leadframe. The leadframe includes: a plurality of pins extending from the center support structure; a groove running perpendicular to the individual pins of the plurality of pins around the center support structure; and a bar connecting the plurality of pins remote from the center support structure. The method further includes: bonding the IC chip to at least some of the plurality of pins; encapsulating the leadframe and bonded IC chip, including filling the groove with encapsulation compound; removing the encapsulation compound from the groove, thereby exposing at least a portion of the individual pins of the plurality of pins; plating the exposed portion of the plurality of pins; performing an isolation cut to isolate individual pins of the IC package without separating the IC package from the lead frame; and performing a circuit test of isolated individual pins after the isolation cut; cutting the IC package free from the bar by sawing through the encapsulated lead frame along the groove using a first saw width less than a width of the groove; and attaching the flat no-leads IC package to the PCB using a reflow soldering method to join the plurality of pins of the IC package to respective contact points on the PCB.

The isolation cut is performed with a second saw width less than the width of the groove.

Some embodiments may include bonding the IC chip to at least some of the plurality of pins using wire bonding.

In some embodiments, the width of the groove is 0.40 mm

In some embodiments, the first saw width is 0.30 mm.

In some embodiments, the second saw width is between 0.24 mm and 0.30 mm.

According to the first aspect of the invention, the groove is 0.1 mm to 0.15 mm deep and the leadframe has a thickness of 0.20 mm.

According to the first aspect of the invention, the reflow soldering process provides fillet heights of 60% of the exposed surface of the pins.

The second aspect of the invention provides an integrated circuit (IC) device in a flat no-leads package, installed on a printed circuit board, comprising: an IC chip mounted onto a center support structure of a pre-grooved leadframe and encapsulated with the leadframe to form an IC package having a bottom face and four sides; the pre-grooved leadframe including a set of pins extending from the center support structure, a groove running perpendicular to the individual pins of the plurality of pins around the center support structure, and a bar connecting the plurality of pins remote from the center support structure; the set of pins having faces exposed along a lower edge of the four sides of the IC package; and the groove running around a perimeter of the bottom face of the IC package, including the exposed faces of the set of pins; wherein a bottom facing exposed portion of the plurality of pins including the groove is plated, the groove having a depth of 0.10 mm to 0.15, the pre-grooved leadframe having a thickness of 0.20mm, and individual pins of the plurality of pins are attached to a printed circuit board so that fillet heights of 60% of the exposed surface of the pins are achieved.

### BRIEF DESCRIPTION OF THE DRAWINGS

Figure 1 is a schematic showing a cross section side view through an embodiment of a flat no-leads package mounted on a printed circuit board (PCB) according to the teachings of the present disclosure;
Figure 2A is a picture showing part of a typical QFN package in a side view and bottom view. Figure 2B shows an enlarged view of the face of copper contact pins along the edge of QFN package exposed by sawing through an encapsulated leadframe.
Figure 3 is a picture showing a typical QFN package after a reflow soldering process failed to provide sufficient mechanical and electrical connections to a PCB.
Figures 4A and 4B are pictures showing a partial view of a packaged IC device incorporating teachings of the present disclosure in a flat no-leads package with high wettable flanks for use in reflow soldering.
Figure 5A is a picture of the packaged IC device of Figure 4 after a reflow soldering process provided an improved solder connection; Figure 5B is a schematic drawing showing an enlarged detail of the improved solder connection.
Figure 6 is a drawing showing a top view of a leadframe which may be used to practice the teachings of the present disclosure.
Figure 7 is a flowchart illustrating an example method for manufacturing an integrated circuit (IC) device in a flat no-leads package incorporating teachings of the present disclosure.
Figures 8A and 8B are schematic drawings illustrating part of an example method for manufacturing an integrated circuit (IC) device in a flat no-leads package incorporating teachings of the present disclosure.
Figures 8C and 8D are pictures of an IC device package after the process step of Figs. 8A-8D has been completed.
Figure 9 is a schematic drawing illustrating part of an example method for manufacturing an integrated circuit (IC) device in a flat no-leads package incorporating teachings of the present disclosure.
Figures 10A and 10B are schematic drawings illustrating part of an example method for manufacturing an integrated circuit (IC) device in a flat no-leads package incorporating teachings of the present disclosure.
Figures 11A and 11B are schematic drawings illustrating part of an example method for manufacturing an integrated circuit (IC) device in a flat no-leads package incorporating teachings of the present disclosure.
Figure 11C is a picture of an IC device package after the process step of Figs. 11A and 11B have been completed and the tin plate has been removed from the top of the chip.

### BRIEF DESCRIPTION OF THE EMBODIMENTS

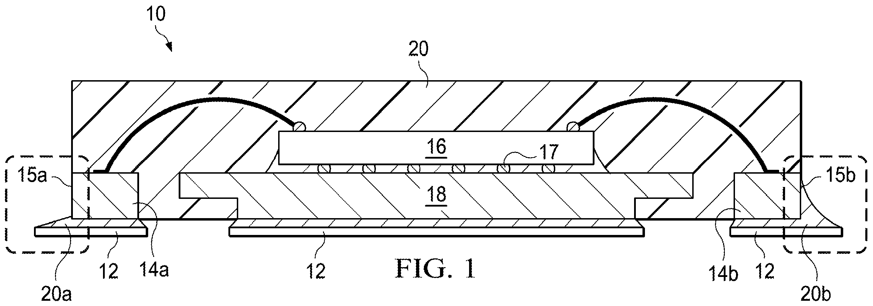

Figure 1 is a schematic drawing showing a side view of a cross section view through a flat no-leads package 10 mounted on a printed circuit board (PCB) 12. Package 10 includes contact pins 14a, 14b, die 16, leadframe 18, and encapsulation 20. Die 16 may include any integrated circuit, whether referred to as an IC, a chip, and/or a microchip. Die 16 may include a set of electronic circuits disposed on a substrate of semiconductor material, such as silicon. Die 16 may be mounted to leadframe 18 by adhesive 17 using any appropriate mounting process.

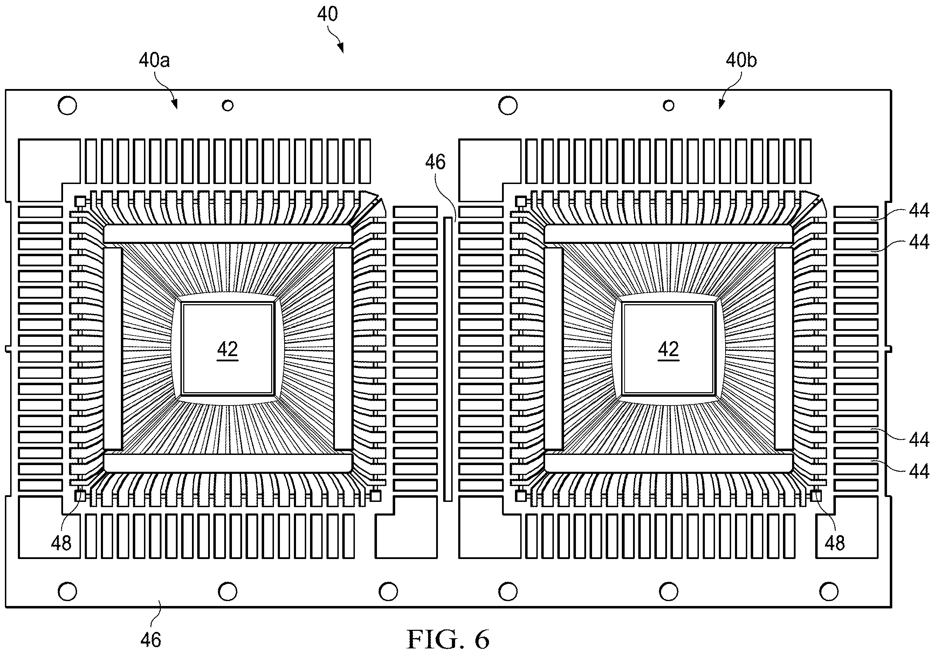

As shown in Figure 1, contact pin 14a is the subject of a failed reflow process in which the solder 20a did not stay attached to the exposed vertical face (or "flank") 15a of contact pin 14a. The bare copper flank 15a of contact pin 14a created by sawing the package 10 free from a leadframe matrix (shown in more detail in Figure 6 and discussed below) may contribute to such failures. In contrast, contact pin 14b shows an improved soldered connection 20b upward along flank 15b, created by a successful reflow procedure. This improved connection provides both electrical communication and mechanical support. The face of contact pin 14b may have been plated before the reflow procedure (*e.g*., with tin plating).

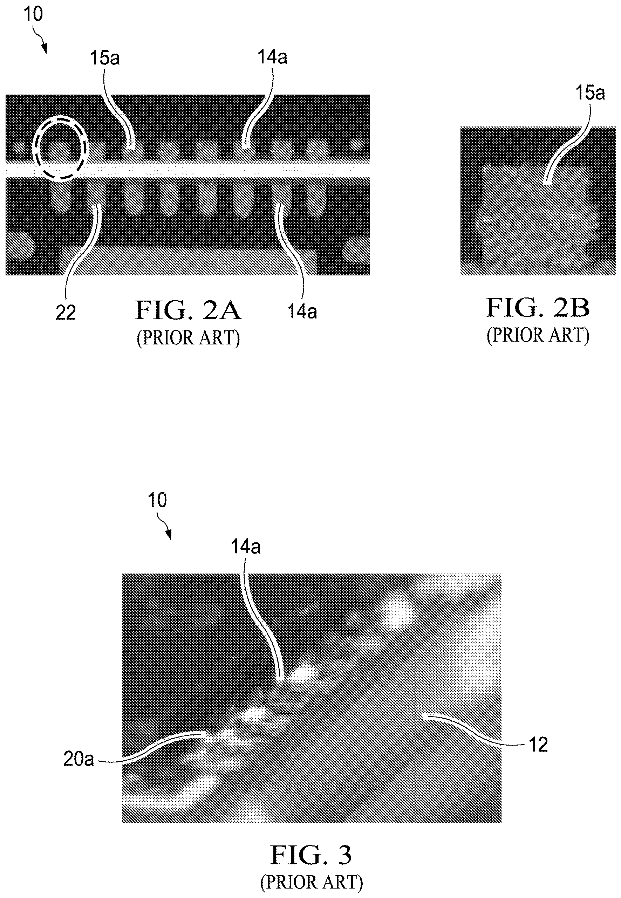

Figure 2A is a picture showing part of a typical QFN package 10 in a side view and bottom view. Figure 2B shows an enlarged view of the face 24 of copper contact pins 14a along the edge of QFN package 10 exposed by sawing through the encapsulated leadframe 18. As shown in Figure 2A, the bottom 22 of contact pin 14a is plated (*e.g*., with tin plating) but the exposed face 15a is bare copper.

Figure 3 is a picture of a typical QFN package 10 after a reflow soldering process failed to provide sufficient mechanical and electrical connections to a PCB 12. As shown in Figure 3, bare copper face 15a of contact pins 14a may provide bad or no connection after reflow soldering. The exposed face 15a of contact pins 14a may not provide sufficient wettable flanks to provide a reliable connection.

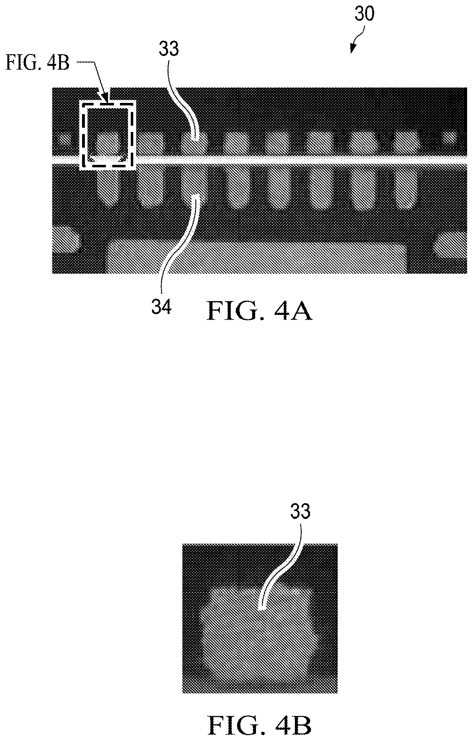

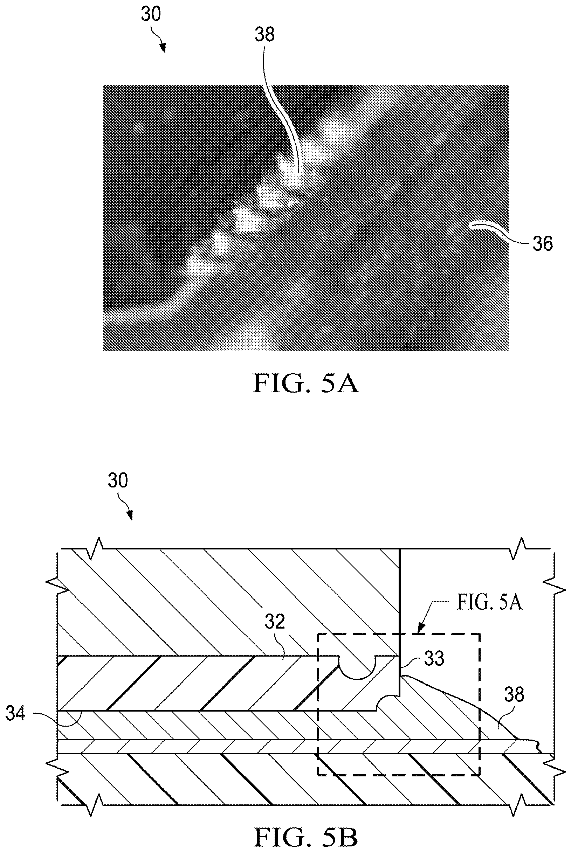

Figures 4A and 4B are pictures showing a partial view of a packaged IC device 30 incorporating the teachings of the present disclosure wherein both the exposed face portion 33 and the bottom surface 34 of the pins 32 have been plated with tin to produce an IC device 30 in a flat no-leads package with high wettable flanks for use in reflow soldering, providing an improved solder connection as shown at contact pin 14b in Figure 1 and demonstrated in the picture of Figure 5. As shown, IC device 30 may comprise a quad-flat no-leads packaging. In other embodiments, IC device 30 may comprise a dual-flat no-leads packaging, or any other packaging (*e.g*., any micro leadframe (MLT)) in which the leads do not extend much beyond the edges of the packaging and which is configured to surface-mount the IC to a printed circuit board (PCB).

Figure 5A is a picture showing packaged IC device 30 with plating on both exposed face portion 33 of the pins 32 and the bottom surface 34 of pins 32, demonstrating the improved connection after a reflow soldering process connecting to a PCB 36. Figure 5B is a drawing showing an enlarged cross-sectional detail of IC device 30 after attachment to PCB 36 using a reflow soldering process. As is visible in Figures 5A and 5B, solder 38 is connected to pins 32 along both the bottom surface 34 and the face portion 33.

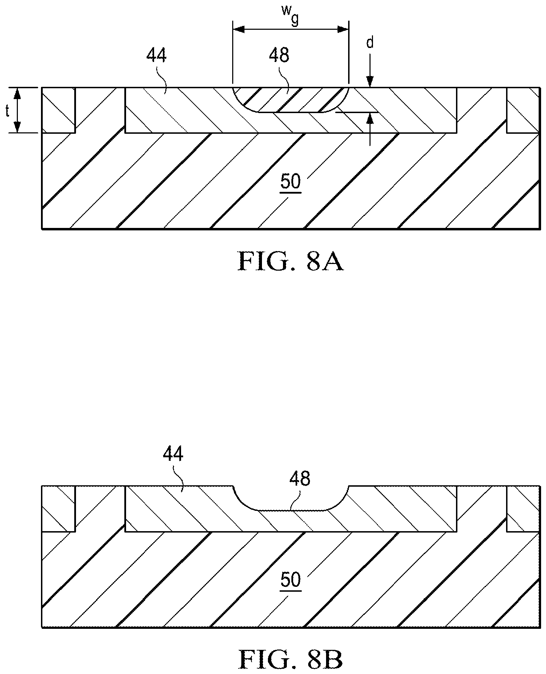

Figure 6 shows a leadframe 40 which may be used to practice the teachings of the present disclosure. As shown, leadframe 40 may include a center support structure 42, a plurality of pins 44 extending from the center support structure, and one or more bars 46 connecting the plurality of pins remote from the center support structure. The one or more bars 46 may include a groove 48 running perpendicular to the individual bars. Groove 48 is discussed in more detail in relation to Figures 8A and 8B. As shown in Figure 6, the groove 48 may be essentially square and extend around the center support structure 42.

Leadframe 40 may include a metal structure providing electrical communication through the pins 44 from an IC device (not shown in Figure 6) mounted to center support structure 42 as well as providing mechanical support for the IC device. In some applications, an IC device may be glued to center support structure 42. In some embodiments, the IC device may be referred to as a die. In some embodiments, pads or contact points on the die or IC device may be connected to respective pins by bonding (*e.g*., wire bonding, ball bonding, wedge bonding, compliant bonding, thermosonic bonding, or any other appropriate bonding technique). In some embodiments, leadframe 40 may be manufactured by etching or stamping. Leadframe 40 may be part of a matrix of leadframes 40a, 40b for use in batch processing.

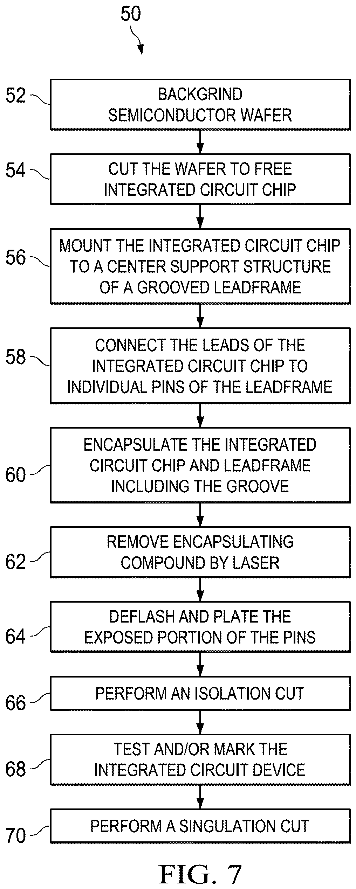

Figure 7 is a flowchart illustrating an example method 50 for manufacturing an integrated circuit (IC) device in a flat no-leads package incorporating teachings of the present disclosure. Method 50 may provide improved connection for mounting the IC device to a PCB.

Step 52 may include backgrinding a semiconductor wafer on which an IC device has been produced. Typical semiconductor or IC manufacturing may use wafers approximately 750 µm thick. This thickness may provide stability against warping during high-temperature processing. In contrast, once the IC device is complete, a thickness of only 50 µm to 75 µm may be remaining. Backgrinding (also called backlap or wafer thinning) may remove material from the side of the wafer opposite the IC device.

Step 54 may include sawing and/or cutting the wafer to separate the IC device from other components formed on the same wafer.

Step 56 includes mounting the IC die (or chip) on a center support structure of a grooved leadframe. The IC die may be attached by the center support structure by gluing or any other appropriate method including epoxy and/or another adhesive.

At Step 58, the IC die may be connected to the individual pins extending from the center support structure of the leadframe. In some embodiments, pads and/or contact points on the die or IC device may be connected to respective pins by bonding (*e.g*., wire bonding, ball bonding, wedge bonding, compliant bonding, thermosonic bonding, or any other appropriate bonding technique).

At Step 60, the IC device and leadframe, including the groove, is encapsulated to form an assembly. In some embodiments, this includes molding into a plastic case. If a plastic molding is used, a post-molding cure step may follow to harden and/or set the housing.

At Step 62, the groove of the encapsulated assembly may be cleared by a laser removal process. Any encapsulation compound may be cleared out, leaving the original groove as made in the leadframe. In some embodiments, the groove width may be approximately 0.4 mm. The groove depth is 0.1-0.15 mm deep into a leadframe having a thickness of 0.2 mm. The groove does not, therefore, cut all the way through the pins.

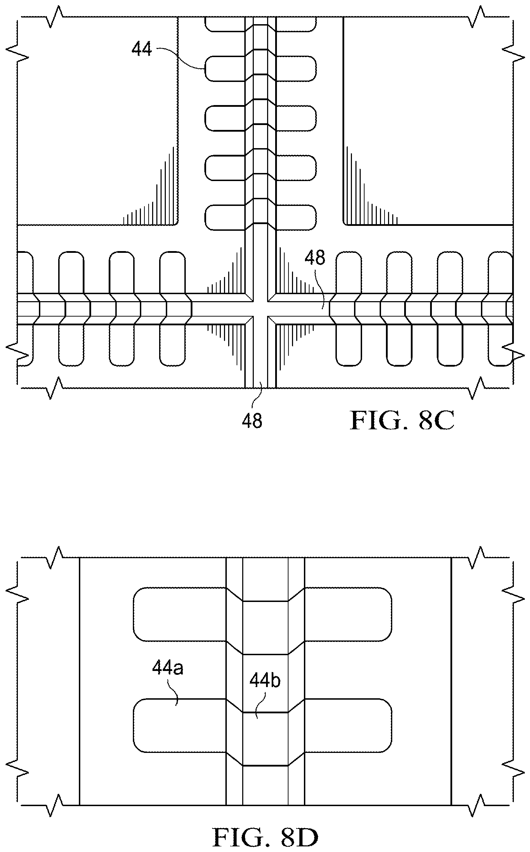

Figure 8 illustrates one embodiment of a laser grooving process that may be used at Step 62, with Figures 8A and 8B including schematics showing a side view of Step 62. As shown in Figure 8A, pins 44 are encapsulated in a plastic molding 50. Pins 44 and/or any other leads in leadframe 40 may have a thickness, *t.* As shown in Figure 8A, the groove width, *W*_{g}, and depth, *d,* do not physically separate the pins 44 from neighboring packages. In some embodiments, the groove width is approximately 0.4 mm. Figure 8B shows pins 44 exposed along the bottom surface 44a and groove 48. Figures 8C and 8D are isometric views showing pins 44 after Step 62 has been completed.

Step 64 may include a chemical de-flashing and a plating process to cover the exposed bottom areas of the connection pins 44. The pins may be plated with tin and/or any appropriate conductive material chosen to form a good wettable surface for soldering processes.

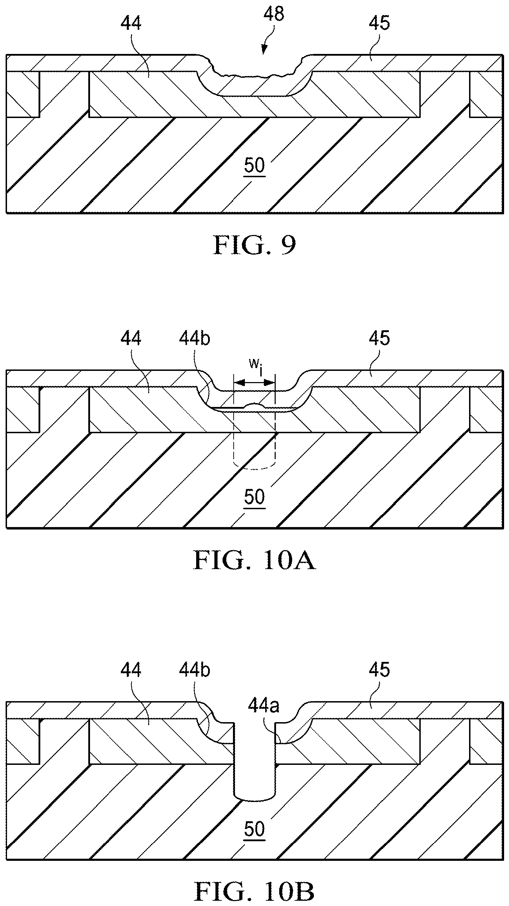

Figure 9 illustrates the results of one embodiment of a plating process that may be used at Step 64. Figure 9 is a schematic side view in cross section showing pins 44 encapsulated in plastic molding 48, after groove 48 is cleared as discussed in relation to Step 62. In addition, plating 45 has been deposited on the exposed surfaces of pins 44, including the bottom surfaces 44a and step groove 48.

Step 66 includes performing an isolation cut. The isolation cut includes sawing through the pins running between two packages to electrically isolate the dies from one another. The isolation cut is made using a saw width, wᵢ, less than the groove width. In some embodiments, the isolation cut may be made with a blade having a thickness of approximately 0.24 mm.

Figure 10 illustrates a process of one embodiment of an isolating cut that may be used at Step 66. Figures 10A and 10B are schematic drawings showing a cross-sectional side view of pins 44 encapsulated in plastic molding 50 and after groove clearance and plating of the exposed surfaces. After plating 45 has been deposited in Step 64, an isolation cut of width *w*ᵢ is made beyond the full thickness *t* of pins 44 as shown in Figure 10B. *w*ᵢ is narrower than the width of the groove 48, leaving at least a portion of the plated step cut remaining after the isolation cut. In contrast to the depth of the groove 48, the depth of the isolation cut is larger than the total thickness t of pins 44 so that the individual pins 44 and circuits of leadframe 40 will no longer be in electrical communication through the matrix of leadframes and/or bar 46.

Step 68 may include a test and marking of the IC device once the isolation cut has been completed.

Step 70 includes a singulation cut to separate the IC device from the bar, the leadframe, and/or other nearby IC devices in embodiments where leadframe 40 is part of a matrix of leadframes 40. The singulation cut includes sawing through the same cutting lines as the groove and/or the isolation cut with a saw width less than the full width of groove 48. In some embodiments, the singulation saw width may be approximately 0.3 mm. The singulation cut exposes only a portion of the bare copper of the pins of the leadframe. Another portion of the pins remain plated and unaffected by the final sawing step.

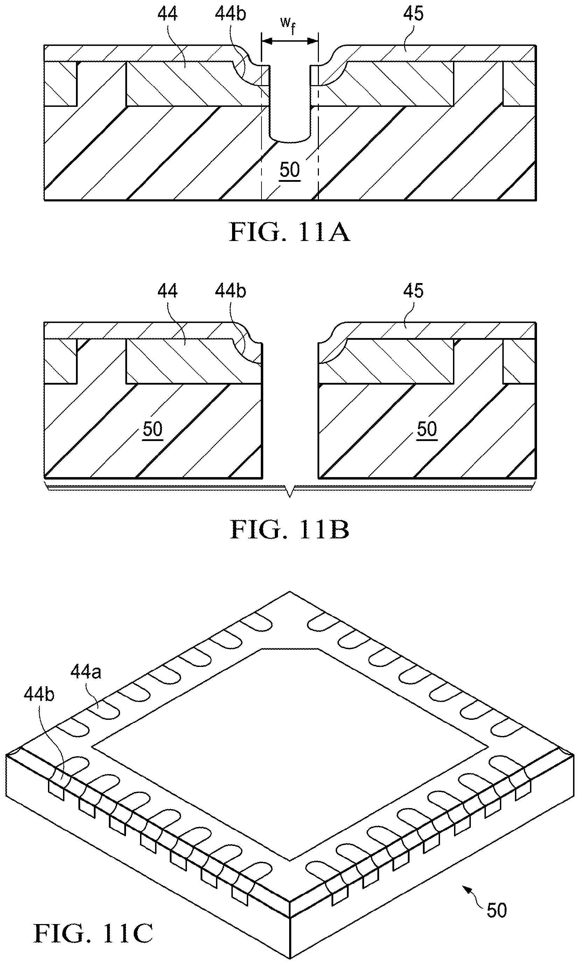

Figure 11 illustrates a process of one embodiment of a singulation cut that may be used at Step 70. Figures 11A and 11B are schematic drawings showing a cross-sectional side view of pins 44 encapsulated in plastic molding 48 and after a step cut, plating of the exposed surfaces, and an isolation cut. After any testing and/or marking in Step 68, a singulation cut of width *w*_{f} is made through the full package as shown in Figure 11B. *w*_{f} is narrower than *w*_{g} leaving at least a portion of the plated step cut remaining after the singulation cut. Figure 11C is a picture showing pins 44 after Step 66 is complete.

After Step 70, method 50 includes attaching the separated IC device, in its package, to a PCB or other mounting device. The IC device is attached to a PCB using a reflow soldering process. Figure 5B shows a view of the pin area of an IC device that has been mounted on a printed circuit board and attached by a reflow solder process. The groove provided by the present disclosure can increase the wettable flanks or fillet height to 60% and meet, for example, automotive customer requirements. Thus, according to various teachings of the present disclosure, the "wettable flanks" of a flat no-leads device may be improved and each solder joint made by a reflow soldering process may provide improved performance and/or increased acceptance rates during visual and/or performance testing.

Method 50 may offer improved precision and/or accuracy in the dimensions of groove 48. For example, the width and/or depth may be more reliable in a predefined groove 48 in comparison to cutting a new groove after packaging using a saw blade. Saw cutting may have relatively large width and/or depth variations resulting at least in part from wear and tear of the blade. In some cases, cutting a groove with a saw blade may produce copper burrs along portions of the groove. Laser grooving as described above shows low variation of both the cutting depth and fillet height. Further, there is no evidence of a copper burr generated by laser grooving.

In contrast, a conventional manufacturing process for a flat no-leads integrated circuit package may leave pin connections without sufficient wettable surface for a reflow solder process. Even if the exposed pins are plated before separating the package from the leadframe or matrix, the final sawing step used in a typical process leaves only bare copper on the exposed faces of the pins.

## Claims

1. A method for manufacturing an integrated circuit (IC) device in a flat no-leads package (10) and installing the device on a printed circuit board, the method comprising:
providing a pre-grooved leadframe (40);
mounting an IC chip onto a center support structure (42) of the pre-grooved leadframe (40), the pre-grooved leadframe (40) including:
a plurality of pins (44) extending from the center support structure (42);
a groove (48) running perpendicular to the individual pins (44) of the plurality of pins (44) around the center support structure (42); and
a bar (46) connecting the plurality of pins (44) remote from the center support structure (42);
bonding the IC chip to at least some of the plurality of pins (44);
encapsulating the pre-grooved leadframe (40) and bonded IC chip, including filling the groove (48) with encapsulation compound;
removing the encapsulation compound from the groove (48), thereby exposing at least a portion of the individual pins (44) of the plurality of pins (44);
plating the exposed portion of the plurality of pins (44);
performing an isolation cut using a second saw width less than a width of the groove (48) to isolate individual pins (44) of the IC package (10) without separating the IC package (10) from the lead frame (40);
performing a circuit test of the isolated individual pins (44) after the isolation cut;
cutting the IC package (10) free from the bar (46) by sawing through the encapsulated lead frame (40) along the groove (48) using a first saw width less than a width of the groove (48); and
attaching the flat no-leads IC package (10) to a printed circuit board using a reflow soldering method to join the plurality of pins (44) of the IC package (10) to respective contact points on the printed circuit board; wherein
the groove (48) is 0.1 mm to 0.15 mm deep, the pre-grooved leadframe (40) has a thickness of 0.20 mm, and individual pins (44) of the plurality of pins (44) are attached to the printed circuit board with fillet heights of 60% of the exposed surface of the pins (44).

2. The method according to claim 1, further comprising bonding the IC chip to at least some of the plurality of pins (44) using wire bonding.

3. The method according to any of claims 1-2, wherein the width of the groove (48) is 0.40 mm.

4. The method according to any of claims 1-3, wherein the first saw width is 0.30 mm.

5. The method according to any of claims 1-4, wherein the second saw width is between 0.24 mm and 0.30 mm.

6. An integrated circuit (IC) device in a flat no-leads package (10), installed on a printed circuit board, comprising:
an IC chip mounted onto a center support structure (42) of a pre-grooved leadframe (40) and encapsulated with the pre-grooved leadframe (40) to form an IC package (10) having a bottom face and four sides;
the pre-grooved leadframe (40) including a set of pins (44) extending from the center support structure (42), a groove (48) running perpendicular to the individual pins (44) of the plurality of pins (44) around the center support structure (42) , and a bar (46) connecting the plurality of pins (44) remote from the center support structure (42);
the set of pins (44) having faces exposed along a lower edge of the four sides of the IC package (10); and
the groove (48) running around a perimeter of the bottom face of the IC package (10), including the exposed faces of the set of pins (44);
**characterized in that**
the groove (48) having a depth of is 0.1 mm to 0.15 mm and the pre-grooved leadframe (40) has a thickness of 0.20 mm;
wherein a bottom facing exposed portion of the plurality of pins (44) including the groove (48) is plated; and wherein
individual pins (44) of the plurality of pins (44) are attached to the printed circuit board with fillet heights of 60% of the exposed surface of the pins (44).

## Patentansprüche

1. Verfahren zum Herstellen einer integrierten Schaltungs- (IC-) Vorrichtung in einem flachen, anschlussfreien Gehäuse (10) und Installieren der Vorrichtung auf einer gedruckten Schaltungsplatine, wobei das Verfahren aufweist:
Bereitstellen eines vorgenuteten Leiterrahmens (40);
Montieren eines IC-Chips auf einer mittigen Stützstruktur (42) des vorgenuteten Leiterrahmens (40), wobei der vorgenutete Leiterrahmen (40) aufweist:
eine Vielzahl von Pins (44), die sich von der mittigen Stützstruktur (42) erstrecken;
eine Nut (48), die senkrecht zu den einzelnen Pins (44) der Vielzahl von Pins (44) um die mittige Stützstruktur (42) verläuft; und
ein Stab (46), der die Vielzahl von Pins (44) entfernt von der mittigen Stützstruktur (42) verbindet;
Bonden des IC-Chips an zumindest einige der Vielzahl von Pins (44);
Einkapseln des vorgenuteten Leiterrahmens (40) und des gebondeten IC-Chips, einschließlich Füllen der Nut (48) mit Einkapselungsmasse;
Entfernen der Einkapselungsmasse aus der Nut (48), wodurch zumindest ein Teil der einzelnen Pins (44) der Vielzahl von Pins (44) freigelegt wird;
Plattieren des freigelegten Abschnitts der Vielzahl von Pins (44);
Durchführen eines Isolationsschnitts unter Verwendung einer zweiten Sägebreite, die kleiner als eine Breite der Nut (48) ist, um einzelne Pins (44) des IC-Gehäuses (10) zu isolieren, ohne das IC-Gehäuse (10) von dem Leiterrahmen (40) zu trennen;
Durchführen eines Schaltungstests der isolierten einzelnen Pins (44) nach dem Isolationsschnitt;
Freischneiden des IC-Gehäuses (10) von dem Stab (46) durch Sägen durch den eingekapselten Leiterrahmen (40) entlang der Nut (48) unter Verwendung einer ersten Sägebreite, die kleiner als eine Breite der Nut (48) ist; und
Anbringen des flachen IC-Gehäuses (10) ohne Anschlüsse an einer gedruckten Schaltungsplatine unter Verwendung eines Aufschmelzlötverfahrens, um die Vielzahl von Pins (44) des IC-Gehäuses (10) mit jeweiligen Kontaktpunkten auf der gedruckten Schaltungsplatine zu verbinden; wobei
die Nut (48) 0,1 mm bis 0,15 mm tief ist, der vorgenutete Leiterrahmen (40) eine Dicke von 0,20 mm aufweist und einzelne Pins (44) der Vielzahl von Pins (44) an der gedruckten Schaltungsplatine mit Hohlkehlenhöhen von 60 % der freigelegten Oberfläche der Pins (44) befestigt sind.

2. Verfahren nach Anspruch 1, das weiterhin das Bonden des IC-Chips an zumindest einige der Vielzahl von Pins (44) unter Verwendung von Drahtbonden aufweist.

3. Verfahren nach einem der Ansprüche 1 bis 2, wobei die Breite der Nut (48) 0,40 mm beträgt.

4. Verfahren nach einem der Ansprüche 1 bis 3, wobei die erste Sägebreite 0,30 mm beträgt.

5. Verfahren nach einem der Ansprüche 1 bis 4, wobei die zweite Sägebreite zwischen 0,24 mm und 0,30 mm liegt.

6. Integrierte Schaltungs- (IC-) Vorrichtung in einem flachen, anschlussfreien Gehäuse (10), installiert auf einer gedruckten Schaltungsplatine, die aufweist:
einen IC-Chip, der auf einer mittigen Trägerstruktur (42) eines vorgenuteten Leiterrahmens (40) montiert und mit dem vorgenuteten Leiterrahmen (40) eingekapselt ist, um ein IC-Gehäuse (10) mit einer Bodenfläche und vier Seiten auszubilden;
wobei der vorgenutete Leiterrahmen (40) einen Satz von Pins (44) aufweist, die sich von der mittigen Stützstruktur (42) erstrecken, wobei eine Nut (48) senkrecht zu den einzelnen Pins (44) der Vielzahl von Pins (44) um die mittige Stützstruktur (42) herum verläuft, und einen Stab (46), der die Vielzahl von Pins (44) entfernt von der mittigen Stützstruktur (42) verbindet;
wobei der Satz von Pins (44) Flächen aufweist, die entlang einer unteren Kante der vier Seiten des IC-Gehäuses (10) freigelegt sind; und
wobei die Nut (48) um einen Umfang der Bodenfläche des IC-Gehäuses (10) herum verläuft, einschließlich der freigelegten Flächen des Satzes von Pins (44);
**dadurch gekennzeichnet, dass**
die Nut (48) eine Tiefe von 0,1 mm bis 0,15 mm aufweist und der vorgenutete Leiterrahmen (40) eine Dicke von 0,20 mm aufweist;
wobei ein dem Boden zugewandter freiliegender Abschnitt der Vielzahl von Pins (44) einschließlich der Nut (48) plattiert ist; und wobei
einzelne Pins (44) der Vielzahl von Pins (44) an der gedruckten Schaltungsplatine mit Hohlkehlenhöhen von 60 % der freigelegten Oberfläche der Pins (44) angebracht sind.

## Revendications

1. Procédé de fabrication d'un dispositif à circuit intégré (CI) dans un boîtier plat sans conducteurs (10) et d'installation du dispositif sur une carte de circuit imprimé, le procédé comprenant :
la fourniture d'une grille de connexion pré-rainurée (40) ;
le montage d'une puce de CI sur une structure de support centrale (42) de la grille de connexion pré-rainurée (40), la grille de connexion pré-rainurée (40) comprenant :
une pluralité de broches (44) s'étendant depuis la structure de support centrale (42) ;
une rainure (48) s'étendant perpendiculairement aux broches individuelles (44) parmi la pluralité de broches (44) autour de la structure de support centrale (42) ; et
une barre (46) reliant la pluralité de broches (44) distante de la structure de support centrale (42) ;
la soudure de la puce de CI à au moins certaines parmi la pluralité de broches (44) ;
l'encapsulation de la grille de connexion pré-rainurée (40) et de la puce de CI soudée, y compris le remplissage de la rainure (48) avec un composé d'encapsulation ;
le retrait du composé d'encapsulation de la rainure (48), exposant ainsi au moins une partie des broches individuelles (44) parmi la pluralité de broches (44) ;
le plaquage de la partie exposée de la pluralité de broches (44) ;
l'exécution d'une coupure d'isolation au moyen d'une seconde largeur de scie inférieure à une largeur de la rainure (48) pour isoler les broches individuelles (44) du boîtier de CI (10) sans séparer le boîtier de CI (10) de la grille de connexion (40) ;
l'exécution d'un test de circuit des broches individuelles isolées (44) après la coupure d'isolation ;
la libération du boîtier de CI (10) de la barre (46) en sciant à travers la grille de connexion (40) encapsulée le long de la rainure (48) au moyen d'une première largeur de scie inférieure à une largeur de la rainure (48) ; et
la fixation du boîtier de CI plat sans conducteurs (10) à une carte de circuit imprimé au moyen d'un procédé de soudage par refusion pour souder la pluralité de broches (44) du boîtier de CI (10) à des points de contact respectifs sur la carte de circuit imprimé ; dans lequel
la rainure (48) a une profondeur comprise entre 0,1 mm et 0,15 mm, la grille de connexion pré-rainurée (40) a une épaisseur de 0,20 mm, et les broches individuelles (44) parmi la pluralité de broches (44) sont fixées à la carte de circuit imprimé avec des hauteurs de congé représentant 60 % de la surface exposée des broches (44).

2. Procédé selon la revendication 1, comprenant en outre la soudure de la puce de CI à au moins certaines parmi la pluralité de broches (44) au moyen d'une soudure de fils.

3. Procédé selon l'une quelconque des revendications 1 et 2, dans lequel la largeur de la rainure (48) est de 0,40 mm.

4. Procédé selon l'une quelconque des revendications 1 à 3, dans lequel la première largeur de scie est de 0,30 mm.

5. Procédé selon l'une quelconque des revendications 1 à 4, dans lequel la seconde largeur de scie est comprise entre 0,24 mm et 0,30 mm.

6. Dispositif de circuit intégré (CI) dans un boîtier plat sans conducteurs (10), installé sur une carte de circuit imprimé, comprenant :
une puce de CI montée sur une structure de support centrale (42) d'une grille de connexion pré-rainurée (40) et encapsulée avec la grille de connexion pré-rainurée (40) pour former un boîtier de CI (10) ayant une face inférieure et quatre côtés ;
la grille de connexion pré-rainurée (40) comprenant un ensemble de broches (44) s'étendant depuis la structure de support centrale (42), une rainure (48) s'étendant perpendiculairement aux broches individuelles (44) parmi la pluralité de broches (44) autour de la structure de support centrale (42), et une barre (46) reliant la pluralité de broches (44) distante de la structure de support centrale (42) ;
l'ensemble de broches (44) ayant des faces exposées le long d'un bord inférieur des quatre côtés du boîtier de CI (10) ; et
la rainure (48) s'étendant autour d'un périmètre de la face inférieure du boîtier de CI (10), y compris les faces exposées de l'ensemble de broches (44) ;
**caractérisé en ce que**
la rainure (48) a une profondeur comprise entre 0,1 mm et 0,15 mm et la grille de connexion pré-rainurée (40) a une épaisseur de 0,20 mm ;
dans lequel une partie exposée orientée vers le bas de la pluralité de broches (44) comprenant la rainure (48) est plaquée ; et dans lequel
les broches individuelles (44) parmi la pluralité de broches (44) sont fixées à la carte de circuit imprimé avec des hauteurs de congé représentant 60 % de la surface exposée des broches (44).
